Europäisches Patentamt

European Patent Office

Office européen des brevets

(11) Numéro de publication: **0 236 206**
**A1**

## (12) DEMANDE DE BREVET EUROPEEN

(21) Numéro de dépôt: 87400339.5

(22) Date de dépôt: 17.02.87

(51) Int. Cl.⁴: **H 01 L 27/14**
H 01 L 37/02, H 04 N 3/15

(30) Priorité: 25.02.86 FR 8602582

(43) Date de publication de la demande:
09.09.87 Bulletin 87/37

(84) Etats contractants désignés: DE GB IT NL

(71) Demandeur: THOMSON-CSF
173, Boulevard Haussmann
F-75379 Paris Cedex 08 (FR)

(72) Inventeur: Micheron, François
THOMSON-CSF SCPI 19, avenue de Messine
F-75008 Paris (FR)

Broussoux, Dominique
THOMSON-CSF SCPI 19, avenue de Messine
F-75008 Paris (FR)

Trotel, Jacques
THOMSON-CSF SCPI 19, avenue de Messine
F-75008 Paris (FR)

(74) Mandataire: Lepercque, Jean et al
THOMSON-CSF SCPI 19, avenue de Messine
F-75008 Paris (FR)

(54) Détecteur d'images à mémoire.

(57) Détecteur d'images à mémoire et plus particulièrement, détecteur d'images à lecture par effet thermique.

Ce détecteur comporte principalement une couche (2) d'un matériau photoconducteur et une couche (3) d'un matériau transparent dont l'impédance varie avec la température, ces deux couches étant comprises entre deux électrodes (1 et 4). De plus, un générateur de tension (7) est connectable aux électrodes (1 et 4) durant l'enregistrement lorsque le dispositif est éclairé. Enfin, un amplificateur de charges (8) permet de détecter un courant lorsque l'ensemble est chauffé.

FIG_11

EP 0 236 206 A1

**Description**

DETECTEUR D'IMAGES A MEMOIRE

L'invention concerne un détecteur d'image à mémoire et plus particulièrement un détecteur d'images à lecture par effet thermique.

Le domaine de la demande de brevet est celui des détecteurs d'images à mémoire associant un photoconducteur et un diélectrique, dans lesquels l'adressage à la lecture se fait par balayage d'un faisceau laser, lequel engendre, dans un circuit contenant le détecteur, un photocourant proportionnel à l'illumination reçue par le point adressé. Deux publications sont pertinentes dans ce domaine. Il s'agit de :

1) "A ferroelectric Image Memory" de F. MICHERON, J.M. ROUCHON and M. VERGNOLLE (THOMSON-CSF) publié dans Ferroelectrics 10, 15 (1976)

2) Brevet américain N° 4 446 365 déposé le 1° mai 1984, ayant pour titre "Electrostatic Imaging Method", de P.S. ONG, A.ZERMENO, L.M. MARSH and J.M. HEVEZI.

La première publication décrit un détecteur d'images dans lequel le photoconducteur est associé à un diélectrique ferroélectrique. A l'enregistrement, le ferroélectrique étant initialement dans l'état macroscopiquement dépolarisé, bien qu'en dessous de sa température de Curie (orientation aléatoire des axes polaires des microcristaux le constituant), il est soumis simultanément à l'application via le photoconducteur, d'une tension supérieure à la tension coercitive et à la projection de l'image à enregistrer. Dans les zones très éclairées, la tension est en totalité appliquée au ferroélectrique, et les cristallites s'orientent. Dans les zones de gris, le taux d'orientation est fonction de l'éclairement reçu. Il en résulte dans le ferroélectrique une réplique de l'image enregistrée sous forme de répartition spatiale de polarisation, laquelle est permanente, tant que le ferroélectrique n'est pas chauffé à sa température de Curie, ou soumis à la tension coercitive. La lecture est effectuée par balayage d'un faisceau laser, soit du côté photoconducteur, alors il circule dans le circuit extérieur un photocourant dû au déplacement des photoporteurs qui viennent neutraliser la charge d'espace créée par le ferroélectrique à l'interface ; soit du côté ferroélectrique, alors il circule dans le circuit un courant d'origine pyroélectrique et photoferroélectrique. Ces courants constituent le signal vidéo envoyé à un dispositif d'affichage à tube à rayons cathodiques balayé en synchronisme avec le balayage laser, d'où la restitution de l'image ; on notera que dans ce type de mémoire d'images, la lecture n'est pas destructive.

La seconde publication concerne le même principe, excepté que le diélectrique n'a pas de propriété de mémoire, et que la lecture ne fait intervenir que le mode de neutralisation de la charge d'espace par le photoconducteur éclairé. Dans ce cas, le temps de stockage de l'image enregistrée est fonction des constantes de temps de décharge naturelle (relaxation de Maxwell) du photoconducteur et du diélectrique. Enfin, la lecture est destructive.

Le senseur d'image proposé dans la présente demande de brevet est intermédiaire entre les deux précédents, puisque la lecture peut n'être pas destructive et que le temps de stockage est contrôlé par les temps de relaxation de Maxwell du photoconducteur et du diélectrique ; la lecture est effectuée via la variation d'impédance induite thermiquement dans le diélectrique. Les fondements physiques de ce mode de lecture sont exposés dans la publication suivante :

3) "Propriétés et Applications des diélectriques polarisés :
électrets, polymères orientés et ferroélectriques" de F. MICHERON publié dans la Revue Technique THOMSON CSF N°10, p. 445 (1978).

L'invention concerne donc un détecteur d'images à mémoire, caractérisé en ce qu'il comporte :
- une première électrode en matériau conducteur ;
- une première couche d'un matériau photoconducteur en contact avec la première électrode ;
- une deuxième couche transparente d'un matériau dont l'impédance est variable avec la température, ladite deuxième couche étant juxtaposée à la première couche de matériau photoconducteur ;
- une deuxième électrode transparente en matériau conducteur en contact avec ladite deuxième couche, un générateur de tension d'enregistrement connectable auxdites première et deuxième électrodes ;
- un amplificateur de charge dont deux entrées sont connectables auxdites première et deuxième électrodes et dont une sortie est connectée à un détecteur de charges ; un premier commutateur permettant de connecter au choix, auxdites première et deuxième électrodes, le générateur de tension d'enregistrement ou l'amplificateur de charges ;
- ainsi qu'un moyen de chauffage permettant de chauffer la deuxième couche au moins à l'emplacement situé entre les deux dites électrodes.

L'invention concerne également un procédé de détection d'images à mémoire dans lequel le détecteur a été exposé à des rayonnements déterminant dans la première couche de matériau photoconducteur une répartition de charges caractérisé en ce que la lecture de cette répartition de charges se fait par chauffage de la deuxième couche de matériau à impédance variable.

Les différents objets et caractéristiques de l'invention apparaîtront plus clairement dans la description qui va suivre, faite à titre d'exemple en se reportant aux figures annexées qui représentent :
- la figure 1, un exemple de réalisation du détecteur de l'invention ;
- les figures 2 à 4, des circuits électriques équivalents possibles du détecteur de l'invention ;
- les figures 5 et 6, des schémas électriques de fonctionnement du détecteur de l'invention dans une phase d'enregistrement ;

- les figures 7 et 8, des schémas électriques de fonctionnement du détecteur de l'invention dans une phase de lecture ;
- la figure 9, des courbes de variation de la permittivité en fonction de la température, de matériaux diélectriques ferroélectriques ;
- la figure 10, un exemple de réalisation d'un détecteur d'images selon l'invention réalisé sous la forme d'un écran ;
- la figure 11, une variante de réalisation du détecteur d'images selon l'invention, dans lequel une électrode de chauffage sert également d'électrode de lecture ;
- la figure 12, une autre variante de réalisation du détecteur d'images selon l'invention, dans lequel l'électrode de chauffage est séparée d'une électrode de lecture par une couche d'isolant.

Selon l'invention, l'élément photosensible est un matériau photoconducteur et l'élément de lecture un matériau à impédance dépendant de la température associé à un moyen de chauffage. Le détecteur peut être de type ponctuel, ou associer en ligne des éléments ponctuels pour former une barette, ou associer en matrice les éléments ponctuels pour former une rétine ou un plan. Dans ce dernier cas, le moyen de chauffage est spatialement sélectif, la zone adressée thermiquement pouvant être déplacée à la surface de la rétine pour permettre la sortie en parallèle des informations contenues dans la dite zone. Le matériau photoconducteur est choisi selon l'énergie du rayonnement à détecter, de l'infrarouge, en passant par le visible et les rayons X, jusqu'aux particules de hautes énergies (MeV).

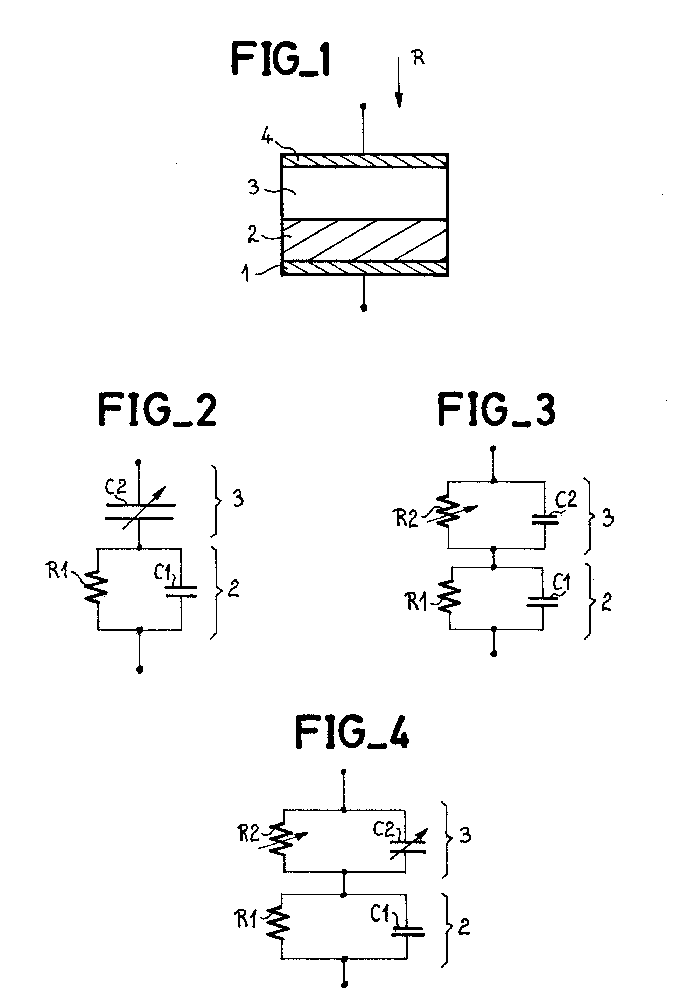

Sur la figure 1, on trouve donc un détecteur selon l'invention qui comprend :
- une couche 2 d'un matériau photoconducteur ;
- une couche 3 d'un matériau dont l'impédance est variable avec la température ;
- deux électrodes 1 et 4 situées de part et d'autre des couches 2 et 3 en contact chacune avec l'une de ces couches.

Le détecteur est éclairé, lors d'un enregistrement, par un rayonnement indiqué par la flèche R. L'électrode 4 qui reçoit ce rayonnement est transparente à la longueur d'onde du rayonnement ainsi que la couche 3 de matériau à impédance variable.

La couche photoconductrice 2 pour le rayonnement considéré est métallisée sur la face inférieure (non soumise au rayonnement) par l'électrode 1. Sa face supérieure est revêtue de la couche 3 de matériau dont l'impédance varie avec la température. Le matériau de la couche 3 et l'électrode supérieure 4 ainsi obtenue sont transparents au rayonnement considéré.

Dans un mode de réalisation préféré de l'invention, le matériau de la couche 3 est un diélectrique, dont la permittivité varie fortement avec la température, tels que des ferroélectriques ou d'autres diélectriques (camphre et ses dérivés) portés au voisinage de transitions structurales. On obtient alors un détecteur dont le schéma électrique équivalent est représenté en figure 2 avec le photoconducteur 2 représenté par la résistance R1 et le condensateur C1 en parallèle, et la couche 3 de matériau diélectrique représentée par un condensateur variable C2.

Selon un autre mode de réalisation, c'est la conductivité du diélectrique qui peut varier (augmenter) avec la température. On obtient ainsi, comme représenté en figure 3, pour la couche 3, un condensateur C2 et une résistance variable R2.

Selon un troisième mode de réalisation, la couche 3 de matériau diélectrique peut avoir sa permittivité et sa conductivité qui augmentent de pair avec la température. On obtient alors un schéma électrique équivalent avec la couche 3 représentée par un condensateur variable C2 et une résistance variable R2.

Dans tous les cas, la couche 3 de matériau diélectrique est considérée comme ayant une conductivité nulle à la température d'enregistrement de l'image.

Dans ce qui suit, c'est le mode thermodiélectrique (variation de permittivité avec la température) qui sera considéré tout d'abord. On admettra de même que la conductivité du photoconducteur est nulle sauf pendant l'illumination.

Le principe d'enregistrement, connu en soi, consiste à obtenir à l'interface diélectrique/photoconducteur une densité de charges fonction de l'illumination. Plusieurs modes sont possibles tels que décrits par exemple dans le livre : "Electrophotography" de R.M. SCHAFFERT, Ed. Focal Press 1971, ainsi que dans le brevet américain N° 4 446 365 cité précédemment. L'un consiste à appliquer une tension V à l'ensemble pendant l'exposition, puis à le court-circuiter après l'exposition.

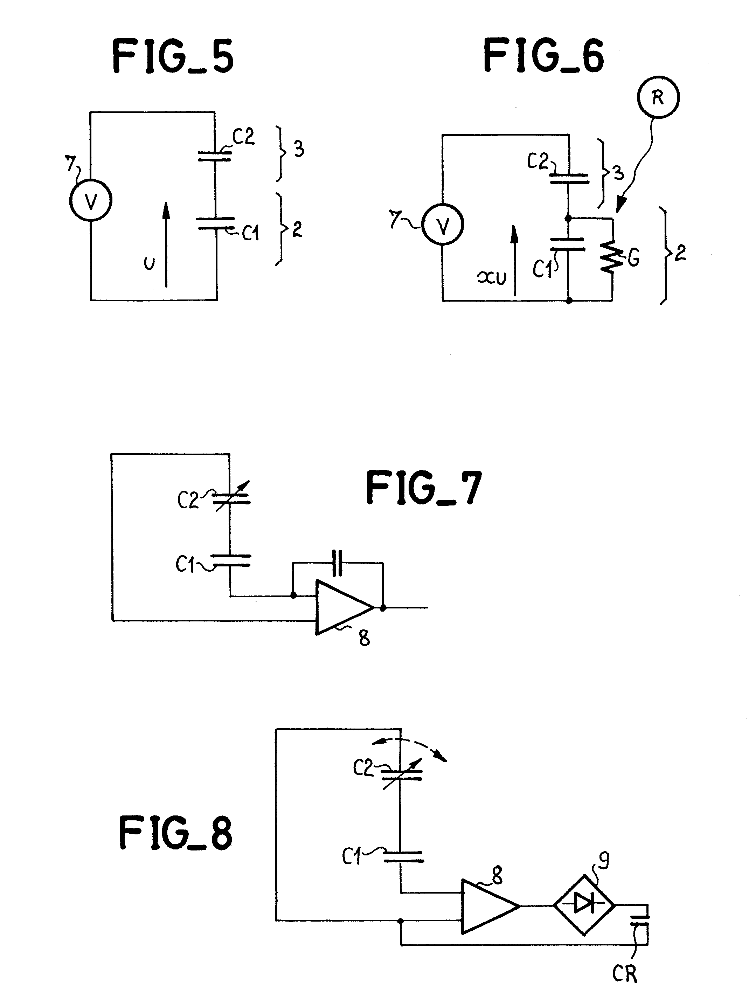

A l'état initial représenté en figure 5 le potentiel appliqué étant V, le potentiel d'interface peut s'écrire :

$$u = V \frac{C_2}{C_1 + C_2}$$

Cependant, en utilisant d'autres moyens, il est possible de rendre ce potentiel u plus élevé.

Lorsque le photoconducteur 2 est soumis au rayonnement R (figure 6) la tension V étant appliquée, le potentiel u décroit, du fait de la conductivité $\sigma$ (I) du photoconducteur ;
on a : $\sigma$ (I) = $\alpha_x \mu \, \tau_p \, \eta \, N$
avec: $\alpha_x$ : coeff. d'absorption du photoconducteur au rayonnement X.

3

$\mu$ et $\tau_p$ : respectivement mobilité et temps de vie des photoporteurs.

$\eta$ : rendement de photoconductivité équivalent au nombre de photoporteurs/nombre de photons absorbés.

N : densité surfacique de photons incidents par seconde équivalent à $l/h\nu$ ($l$ en Watts par mètre carré).

La constante de temps $\tau$ de décroissance est égale au rapport des capacités en parallèle et de la conductance G du photoconducteur. Les couches de matériaux thermodiélectrique et photoconducteur ont la même surface ; leurs épaisseurs et permittivité sont respectivement $e_1$, $\varepsilon_1$ et $e_2$, $\varepsilon_2$

$$d'où \qquad u = V \frac{\varepsilon_2 \, e_1}{e_1 \varepsilon_2 + e_2 \varepsilon_1}$$

$$\tau = \frac{C_1 + C_2}{G} = \frac{e_2 \varepsilon_1 + e_1 \varepsilon_2}{e_2 \, \tau} \quad (I)$$

Le potentiel à l'interface après exposition pendant un temps t est alors :

$$u_t = u \exp - \frac{t}{\tau} = x \, u.$$

Après exposition, les électrodes sont mises en court-circuit. La charge des deux condensateurs se répartit dans la capacité somme, d'où la tension $u_x$ à l'interface :

$$C_2(V - u_t) - C_1 u_t = - (C_1 + C_2) u_x$$

$$soit \quad u_x = - \frac{C_2 V}{C_1 + C_2} \, (1 - x) = - \frac{C_2 V}{C_1 + C_2} \, (1 - e^{-t/\tau})$$

Selon un deuxième mode d'enregistrement, ce potentiel V est appliqué à l'ensemble, qui est exposé uniformément pendant un temps suffisant pour que le potentiel u tombe à 0 ; le potentiel V est ramené à 0. Il s'ensuit qu'à l'interface, le potentiel est :

$$u' = - \frac{C_2 V}{C_1 + C_2} = u_x \, (t_\infty).$$

Le senseur est exposé pendant un temps t au rayonnement de sorte que le potentiel à l'interface devient :

$$u'_x = - \frac{C_2 V}{C_1 + C_2} \, e^{-t/\tau}.$$

Il apparaît donc que $u_x$ et $u'_x$ sont complémentaires :

$$u_x + u'_x = - \frac{C_2 V}{C_1 + C_2}$$

C'est à dire que les deux images correspondant aux deux modes d'enregistrement cités sont de contrastes inversés. On choisira par exemple dans la suite de la description, le premier mode d'enregistrement. Aux faibles temps d'exposition, on obtient :

$$u_x = - \frac{C_2 V}{C_1 + C_2} \; \frac{t}{\tau}$$

En introduisant les valeurs de $\tau$ et de $u$,

$$|u_x| = u \frac{C_2}{(C_1+C_2)2} \qquad GVt = \frac{Gut}{C_1+C_2}$$

Or $Gu$ est le courant de photoconduction $i$, et $i.t$ la charge électronique $Q_x$ déplacée sous irradiation pendant le temps $t$. On vérifie donc que quelles que soient $C_1$ et $C_2$

$(C_1 + C_2) u_x = Q_x$

On a ainsi décrit comment le détecteur de l'invention permet d'enregistrer une image.

En se reportant aux figures 7, 8 et 9, on va maintenant décrire le procédé de lecture thermodiélectrique du détecteur de l'invention.

L'image latente est enregistrée sous forme d'une distribution spatiale de charges à l'interface, soit $q_x = (C_1 + C_2) u_x$ ou $q_x = - C_2 V(L - x)$. Dans le cas du senseur ponctuel, le dispositif est connecté à un amplificateur de charge. Supposons que l'on fasse varier la capacité $C_2$ du diélectrique (par variation d'épaisseur ou de permittivité) le calcul effectué dans le document "Propriétés et Applications des diélectriques polarisés = électrets, polymères orientés et ferroélectriques" de F. MICHERON, précédemment cité, montre que la charge mesurée est proportionnelle à la variation relative de la capacité. Ce mode de lecture tel que représenté en figure 7 s'apparente à l'amplification paramètrique, le gain provenant de la source d'énergie nécessaire pour faire varier la capacité. On voit que ce mode de lecture n'est pas destructif : si la capacité $C_2$ varie alternativement autour de sa valeur moyenne, la charge collectée varie à la même fréquence. Il s'ensuit qu'en redressant en deux alternances le signal issu de l'amplificateur de charge, ce signal redressé peut charger une capacité réservoir CR proportionnellement au nombre de cycles de la capacité variable, d'où un gain de rapport signal à bruit. Un tel fonctionnement est obtenu avec le circuit de la figure 8 où un pont redresseur 9 connecté à l'amplificateur 8 permet de charger le condensateur CR.

Plutôt que de faire varier la capacité $C_2$ électriquement (diode Varicap, diélectrique ferroélectrique à proximité de sa température de Curie ou du champ coercitif) ou mécaniquement, nous proposons de la faire varier thermiquement, par échauffement : cet échauffement peut être obtenu par absorption d'énergie lumineuse ou par effet Joule. L'avantage de la commutation thermodiélectrique tient à ce que circuits d'enregistrement et circuits de lecture sont bien découplés. De plus, le bruit de commutation peut être réduit par rapport à une commutation électrique d'un élément non linéaire (plasma, varistance, etc...).

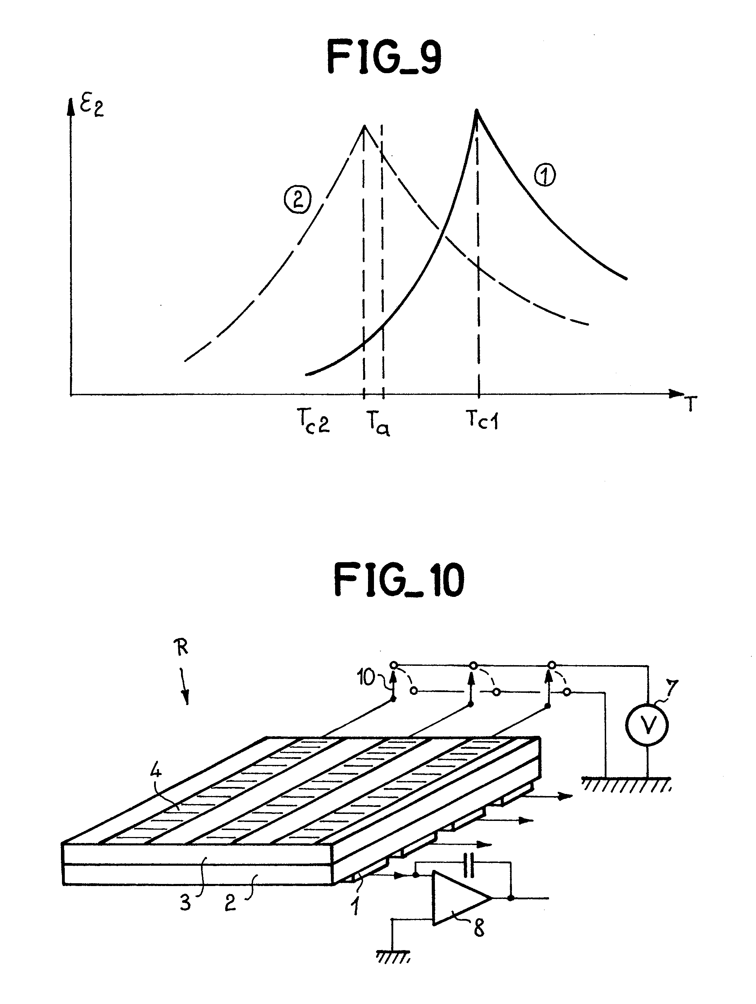

Des variations importantes de permittivité par échauffement peuvent être obtenues dans les diélectriques ferroélectriques ; accroissement lorsque $T_a < T_c$, décroissance lorsque $T_a > T_c$ ainsi que cela est représenté par les courbes 1 et 2 de la figure 9. Ces diélectriques devant être transparents au rayonnement à détecter, des polymères tels que $P(VF_2/TrFE)$ sont bien adaptés (rapport de permittivité maxi à mini de 5 à 10), d'autant plus que l'on peut les obtenir en grandes surfaces homogènes.

Le calcul précédemment cité et publié dans "Propriétés et applications des diélectriques polarisés : électrets, polymères orientés et ferroélectriques" de F. MICHERON, étant un calcul variationnel, n'est pas adapté au cas des grandes variations de capacités considérées ici.

La charge des deux condensations $C_1$ et $C_2$ est constante soit $Q_x = (C_1 + C_2) u_x$ soient $u_x^m$ et $u_x^M$ les tensions d'interface correspondant respecti vement aux valeurs mini $C_2^m$ et maxi $C_2^M$ de la capacité

$Q_x = (C_1 + C_2^m)u_x^m = (C_1 + C_2^M)u_x^M$

La charge lue par variation du condensateur $C_2$ est

$$q_x = C_1 \left[ u_x{}^m - u_x{}^M \right]$$

$$= C_1 \, u_x{}^m \; \frac{C_2{}^M - C_2{}^m}{C_1 + C_2{}^M}$$

$$= C_1 \, u_x{}^M \; \frac{C_2{}^M - C_2{}^m}{C_1 + C_2{}^m}$$

Le rapport de la charge lue $q_x$ à la charge stockée $Q_x$ est

$$S = \frac{C_1}{C_1 + C_2{}^m} \cdot \frac{C_2{}^M - C_2{}^m}{C_1 + C_2{}^M}$$

Pour optimiser la valeur du rapport S, on choisira la valeur de la capacité du condensateur $C_1$, en posant

$$\alpha = \frac{C_2{}^M}{C_2{}^m} \quad \text{et} \quad \beta = \frac{C_2{}^m}{C_1}$$

$$S = \frac{\beta}{1 + \beta} \; \frac{\alpha - 1}{1 + \alpha \, \beta}$$

$$\frac{dS}{d\beta} = (\alpha - 1) \; \frac{1 - \alpha \beta^2}{(1 + \beta)^2 \, (1 + \alpha \beta)^2}$$

Dans ces conditions, S est maximum pour $\alpha \beta^2 = 1$ d'où la valeur correspondante de $C_1$ est donnée par $C_1{}^2$ opt $= C_2{}^m C_2{}^M$

$$\text{et} \quad S \max = \frac{\alpha - 1}{(1 + \sqrt{\alpha})^2}$$

La fluctuation ds max avec celle de $\alpha$ est

$$\frac{dS \max}{d\alpha} = \frac{2}{(1 + \sqrt{\alpha})^3}$$

d'où le tableau donnant les valeurs de $S \max (\alpha)$ et $\frac{ds \max}{d\alpha} (\alpha)$

| α | 1 | 2,5 | 7 | 10 | 25 | 100 | ∞ |
|---|---|-----|---|----|----|-----|---|
| s max | 0 | 0,225 | 0,45 | 0,52 | 0,67 | 0,82 | 1 |
| $\dfrac{ds\ max}{d\alpha}$ | 0,25 | 0,12 | 0,04 | 0,03 | 0,01 | $1,5\ 10^{-3}$ | 0 |

Il ressort de ce tableau que le rendement de lecture est d'autant plus grand et qu'il est d'autant moins affecté par une fluctuation de α que α est plus grand.

On supposera maintenant dans la suite de la description que le détecteur n'est pas ponctuel et a des dimensions par exemple de $40 \times 40$ cm². Il peut alors être considéré comme comportant un ensemble d'éléments détecteurs quasi-ponctuels disposés sous la forme d'une matrice, chaque élément détecteur étant situé au croisement d'une ligne et d'une colonne. La résolution d'un tel détecteur peut être de 200 μm et peut comporter 2000 lignes déposées sous le photoconducteur et 2000 colonnes, déposées sur le diélectrique.

On trouve sur la figure 10 un exemple de réalisation d'un tel détecteur. Ce détecteur comporte une couche plane d'un matériau photoconducteur 2, et une couche 3 d'un matériau dont l'impédance varie avec la température.

La face libre de la couche 2 possède des électrodes, telles que 1, linéaires et parallèles entre elles. On appellera ces électrodes 1, électrodes de lignes.

La face libre de la couche 3 possède des électrodes, telles que 4, linéaires et orthogonales aux électrodes 1. On appellera ces électrodes 4, électrodes de colonnes.

A chaque électrodes de ligne (1) est connecté un amplificateur de lecture.

A chaque électrode de colonne 4 est connecté un commutateur 10 permettant de connecter ladite colonne soit à un potentiel de référence tel que le potentiel 0, soit un générateur de tension 7 fournissant un potentiel V.

A l'enregistrement, toutes les électrodes de lignes sont au potentiel zéro, et toutes les colonnes au potentiel V. A la lecture, chaque ligne est reliée à un amplificateur de charges, et toutes les colonnes sont au potentiel zéro. On remarquera que dans cette disposition, toutes les lignes peuvent être connectées sans commutations aux amplificateurs de charge, pourvu que le potentiel d'entrée de ces amplificateurs soit nul, et que les amplificateurs supportent les variations de charges correspondant aux changements de potentiels imposés aux colonnes.

Pour la lecture, les moyens d'adressage thermique d'un élément détecteur seront décrits ultérieurement.

La charge engendrée par adressage thermodiélectrique d'un élément détecteur apparaît sur la capacité C égale à la somme des capacités des éléments détecteurs d'une même ligne.

Pour un élément détecteur de $200 \times 200$ μm², le nombre minimum de photons X à détecter est environ 10. En supposant un rendement global du photoconducteur de 1000 électrons par photons X absorbé, la charge minimale est :

$Q_{xmin} = 10^4 e^-$, soit $Q_{xmin} = 1,6\ 10^{-15} C$.

La quantité de charges lue est $q_{xmin} = s\ Q_{xmin}$. A température ambiante, la capacité aux bornes de laquelle cette charge est égale à la fluctuation efficace de charge, vaut, pour $s = 0,5$

$$C = \frac{q^2_{x\ min}}{KT} = 1,6\ 10^{-10}\ F.$$

En supposant qu'une ligne telle que 1, comporte N = 2000 éléments détecteurs, la capacité par élément détecteur est :

$C_p = 8.10^{-14}\ F.$

Le cas le plus défavorable pour le bruit correspond au maximum de la capacité d'un élément détecteur qui est celle du photoconducteur pour une valeur $C_2$ voisine de l'infini.

Pour une épaisseur $e_1 = 200$ μm, la constante diélectrique maximale du photoconducteur est :

$$\varepsilon_{1max} \, \varepsilon_0 = \frac{C_p \cdot e_1}{s} = \frac{8.10^{-14}}{200.10^{-6}}$$

d'où $\varepsilon_{1max} = 40.$

La valeur de $s = 0,5$ correspond au rapport :

$$\frac{C_2^M}{C_2^m} = \frac{\varepsilon_2^M}{\varepsilon_2^m} = 10.$$

En utilisant la relation d'optimisation $C_2^M \, C_2^m = C_1^2$, on obtient comme indiqué dans le tableau ci-dessous, pour les photoconducteurs X à permittivités inférieures ou sensiblement égales à 40, les caractéristiques souhaitées pour le thermodiélectrique.

| Photoconducteur | $\varepsilon_1$ | $e_2 = 200 \, \mu m$ | | $e_2 = 100 \, \mu m$ | |
| --- | --- | --- | --- | --- | --- |
| | | $\varepsilon_2^m$ | $\varepsilon_2^M$ | $\varepsilon_2^m$ | $\varepsilon_2^M$ |
| $Bi_{12} \, Si \, O_{20}$ (BSO) | 50 | 16 | 160 | 8 | 80 |
| Cd Te | 11 | 3,5 | 35 | 1,7 | 17 |
| PbO | 24 | 7,6 | 76 | 3,8 | 38 |
| a-Se | 7 | 2,2 | 22 | 1,1 | 11 |

Pour BSO et PbO, la gamme de constantes diélectriques convient aux polymères ferroélectriques de la famille $P(VF_2/VF_3)$, alors que pour CdTe et a-Se, de permittivités plus faibles, ces polymères ne conviendraient qu'en épaisseurs supérieures, ce qui limitera la vitesse de lecture.

Cependant, on peut prendre une épaisseur inférieure à l'épaisseur optimale sans perdre de façon notable en sensibilité. Par exemple, dans les exemples précédents, prendre une épaisseur de la couche 3 de matériau diélectrique, de $e = 30 \, \mu m$ au lieu de $100 \, \mu m$, fait baisser la sensibilité d'environ 0,5 à 0,4. Par contre, cela procure l'avantage de gagner d'un facteur 9 sur le temps de lecture.

Le diélectrique ayant une face libre et une face en contact avec le photoconducteur, on procédera à l'apport de chaleur par la face libre. La durée de l'impulsion de chauffage du diélectrique est choisie en première approximation comme égale au temps de propagation de l'onde thermique dans son épaisseur, soit :

$$t_c = \frac{e^2}{4 D_T}$$

où $D_T$ est la diffusivité thermique

$D_T \simeq 5\ 10^{-8}$ m$^2$ s$^{-1}$ pour un polymère ferroélectrique

$D_T \simeq 3\ 10^{-7}$ m$^2$ s$^{-1}$ pour un oxyde ferroélectrique.

En prenant par exemple un polymère ferroélectrique de 100 μm d'épaisseur, on a :

$$t_c \simeq \frac{10^{-8}}{4 \times 5 \times 10^{-8}} \simeq 50 \text{ ms}$$

On en déduit que dans ce cas, le temps de lecture, pour les 2000 colonnes est $t_2 = 2000\ t_c = 100$ s.

L'énergie nécessaire au chauffage d'un élément d'image est

$W = v.\ C\ \Delta T$

où $v$ = volume d'un élément détecteur

$C$ = chaleur spécifique volumique

et $\Delta T$ l'élévation de température

pour un volume $(100)^3$ μm$^3 = 10^{-12}$m$^3$

$C = 2{,}4\ 10^6$ J.m$^{-3}$K$^{-1}$ (polymère)

et $\Delta T = 100°$

$W_c = 2{,}4\ 10^{-4}$ J

La puissance nécessaire est

$$P_c = \frac{W_c}{t_c} = 5\ 10^{-3} \text{W}$$

soit pour une colonne

$P = 2000\ P_c = 10$ W.

Quel que soit le type de couche à impédance variable avec la température, deux modes de chauffage sont envisagés : chauffage par absorption de photons, ou chauffage par effet Joule. Compte tenu de la durée de propagation de l'onde thermique dans le matériau à impédance variable, on choisira une excitation thermique collective colonne par colonne plutôt que point par point.

Dans le premier mode de chauffage, les colonnes sont revêtues d'une couche absorbante à la longueur d'onde d'excitation ; un laser défléchi en x (lignes) et y (colonnes) vient balayer successivement chaque colonne. Chaque colonne est balayée entre 10 et 100 fois pendant le temps de propagation de l'onde thermique dans la couche à impédance variable, de façon à procurer un échauffement homogène le long de cette colonne.

Ce mode de fonctionnement peut être obtenu avec l'exemple de réalisation représenté en figure 10. La couche 3 et les électrodes de colonnes 4 sont éclairées par un rayonnement R délivré par une source non représentée. Les électrodes de colonnes 4 sont revêtues par une couche absorbante qui permettent d'absorber les photons du rayonnement R et de chauffer dans la couche 3, le matériau voisin de ces électrodes.

Selon une autre variante de réalisation, il est également possible de prévoir un matériau de la couche 3 absorbant le rayonnement R. Il n'est alors pas obligatoire de recouvrir les électrodes de colonnes 4 par un matériau absorbant.

Dans le second mode de fonctionnement, les électrodes de colonnes 4 sont conductrices et sont chauffées par effet Joule, en les faisant traverser par un courant issu d'une source capable de délivrer la puissance nécessaire par ligne (10 W dans l'exemple précédent). Cette variante nécessite un accès et une commutation à chaque extrémité des électrodes de colonnes. Cependant, ce double accès aux colonnes peut être évité en couvrant chaque colonne d'une autre colonne de chauffage, ces deux colonnes superposées étant séparées par un diélectrique mince.

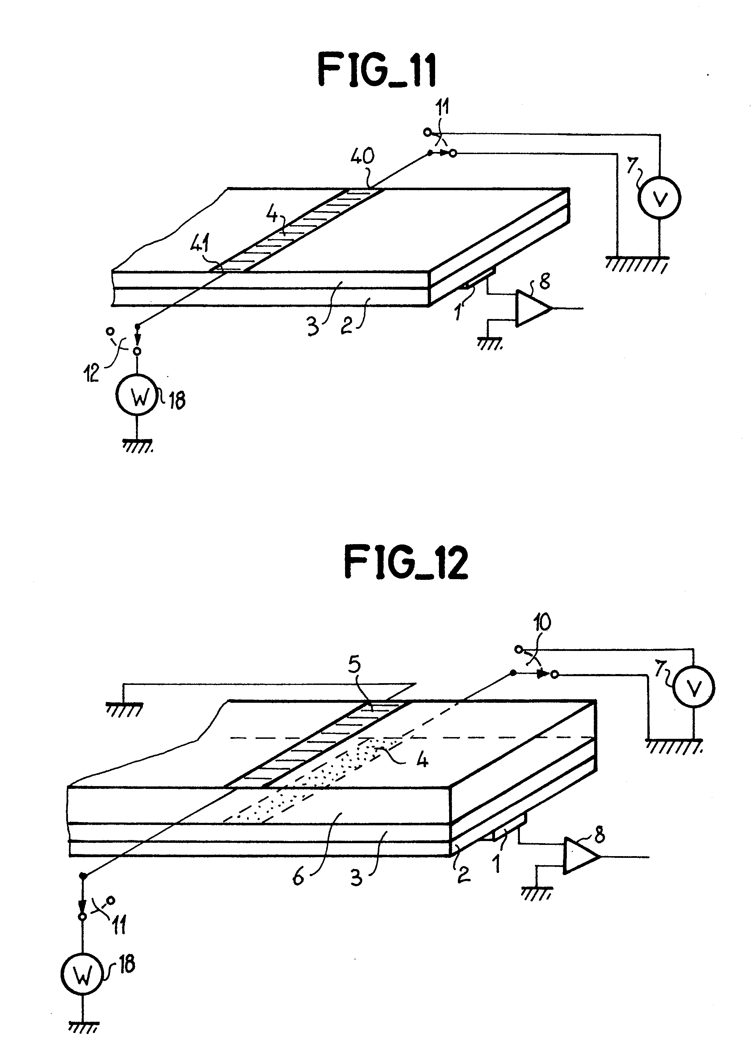

En se reportant à la figure 11, on va décrire la variante de réalisation prévoyant une commutation à chaque extrémité des conducteurs de colonnes.

Sur cette figure, on retrouve le détecteur de la figure 10 dans lequel on a représenté qu'une seule électrode de ligne 1 et une seule électrode de colonne 4 pour simplifier la représentation.

Un premier commutateur 11 permet de connecter une extrémité 40 de l'électrode de colonne 4 soit à un potentiel nul, soit à un potentiel V fourni par le générateur 7.

Un deuxième commutateur 12 permet soit de connecter l'autre extrémité 41 de l'électrode de colonne 4 à un générateur courant 8, soit de l'isoler.

Lors d'un enregistrement, le commutateur 11 connecte l'extrémité 40 de l'électrode de colonne 4 au générateur 7 qui porte ainsi l'électrode 4 au potentiel V. Le commutateur 12 isole l'extrémité 41 de l'électrode 40. L'enregistrement par illumination du détecteur peut alors être réalisée sur toute la colonne située sous l'électrode 4.

Lors d'une lecture, le commutateur 12 connecte l'extrémité 41 au générateur 18. Un courant circule dans l'électrode de colonne 4 qui s'échauffe et élève la température du matériau de la couche 3. La lecture du point de détection situé au croisement de l'électrode de colonne 4 et de l'électrode de ligne 1 peut être réalisée par l'amplificateur 8.

En se reportant à la figure 12, on va décrire la variante de réalisation dans laquelle l'électrode de chauffage est séparée de l'électrode de colonne 4.

Dans cette réalisation, on retrouve une électrode de ligne 1, la couche 2 de matériau photoconducteur, la couche 3 de matériau à impédance variant avec la température, une électrode de colonne connectable par un commutateur 10, comme dans l'exemple de réalisation de la figure 10, soit à un potentiel nul, soit à un générateur 7 fournissant un potentiel V.

Une couche mince 6 d'un matériau diélectrique recouvre la couche 3 et les électrodes de colonne 4. Sur cette couche 6 est arrangée une électrode de chauffage (5). Cette électrode 5 dont une extrémité est à un potentiel nul, à son autre extrémité connectable à un générateur de courant 18 par l'intermédiaire d'un commutateur 11.

Lors d'un enregistrement, le commutateur 10 connecte l'électrode 4 au générateur 7 et l'électrode 5 est déconnectée du générateur 8.

Lors d'une lecture, le commutateur 10 connecte l'électrode 4 au potentiel nul tandis que le commutateur 11 connecte l'électrode 5 au générateur 8 qui fournit un courant provoquant l'échauffement de l'électrode 5.

Il est à noter que selon d'autres variantes de réalisation non représentées, il est possible de prévoir des électrodes qui recouvre toute la surface du détecteur. Notamment, dans l'exemple de réalisation de la figure 10 où le chauffage par le rayonnement R peut se faire de manière sélective, ou bien dans l'exemple de réalisation de la figure 12 où les électrodes de chauffage 5 sont séparées des électrodes de colonnes 4, il est possible au lieu de prévoir une série d'électrodes de colonnes 4 parallèles entre elles, une électrode recouvrant toute la surface de la couche 3 de matériau à impédance variable.

## Revendications

1. Détecteur d'images à mémoire, caractérisé en ce qu'il comporte :
- une première électrode (1) en matériau conducteur ;
- une première couche (2) d'un matériau photoconducteur en contact avec la première électrode ;
- une deuxième couche (3) transparente d'un matériau dont l'impédance est variable avec la température, ladite deuxième couche (3) étant juxtaposée à la première couche (2) de matériau photoconducteur ;
- une deuxième électrode (4) transparente en matériau conducteur en contact avec ladite deuxième couche (3), un générateur de tension d'enregistrement (7) connectable auxdites première et deuxième électrodes (1,4) ;
- un amplificateur de charge (8) dont deux entrées sont connectables auxdites première et deuxième électrodes et dont une sortie est connectée à un détecteur de charges (9) ; un premier commutateur (10) permettant de connecter au choix, auxdites première et deuxième électrodes, le générateur de tension d'enregistrement (7) ou l'amplificateur de charges (8) ;
- ainsi qu'un moyen de chauffage permettant de chauffer la deuxième couche (3) au moins à l'emplacement situé entre les deux dites électrodes (1,4).

2. Détecteur d'images à mémoire selon la revendication 1, caractérisé en ce que le moyen de chauffage comporte une source laser émettant un faisceau vers la deuxième couche (3) située entre la première et la deuxième électrode et le matériau de ladite deuxième couche (3) est de nature à absorber l'échauffement provoqué par le faisceau de la source laser.

3. Détecteur d'images à mémoire selon la revendication 2, caractérisé en ce que le moyen de chauffage comporte au moins une électrode de chauffage (5).

4. Détecteur d'images à mémoire selon la revendication 3, caractérisé en ce que le moyen de chauffage comporte en outre une source laser émettant un faisceau vers l'électrode de chauffage et que celle-ci est revêtue d'une couche absorbante (50) à la longueur d'onde dudit faisceau.

5. Détecteur d'images à mémoire selon la revendication 3, caractérisé en ce que le moyen de chauffage comporte en outre une source de courant électrique de chauffage connectée à l'électrode de chauffage et que celle-ci est en matériau conducteur et est chauffée par effet Joule lorsqu'elle est alimentée en courant électrique.

6. Détecteur d'images à mémoire selon la revendication 5, caractérisé en ce que l'électrode de chauffage (5) est superposée à la deuxième électrode (4) avec une couche (6) d'un matériau diélectrique séparant l'électrode de chauffage (5) et la deuxième électrode (4).

7. Détecteur d'images à mémoire selon la revendication 3, caractérisé en ce que la deuxième électrode (4) est utilisée comme électrode de chauffage.

8. Détecteur d'images à mémoires selon la revendication 5, caractérisé en ce que :
- la deuxième électrode (4) est utilisée comme électrode de chauffage ;
- un deuxième commutateur (11) permet de connecter une première borne (40) de cette deuxième électrode (4) soit à une borne du générateur de tension d'enregistrement (7) durant une opération d'enregistrement, soit à une borne de la source de courant électrique (8) durant une opération de lecture ;
- un troisième commutateur (12) permet soit d'isoler une deuxième borne (41) de la deuxième électrode (4) durant un enregistrement, soit de la connecter à une autre borne de la source de courant électrique (8) durant une lecture.

9. Détecteur d'images à mémoire selon la revendication 1, caractérisé en ce que la deuxième couche (3) est en matériau diélectrique ferroélectrique.

10. Détecteur d'images à mémoire selon l'une quelconque des revendications précédentes, caractérisé en ce que lesdites première et deuxième électrodes (1,4) ainsi que lesdites électrodes de chauffage (5) sont rectilignes et parallèles.

11. Détecteur d'images à mémoire selon la revendication 10, caractérisé en ce qu'il comporte une pluralité d'électrodes des différents types toutes parallèles entre elles et parallèles aux première et deuxième couches (2,3) faisant ainsi un écran d'enregistrement et de lecture.

12. Détecteur d'images à mémoire selon l'une quelconque des revendications 1 à 9, caractérisé en ce qu'il comporte une pluralité de premières électrodes parallèles entre elles et une pluralité de deuxième électrodes orthogonales aux premières électrodes, un amplificateur de charges (8) et un détecteur de charges (9) étant connecté à chaque première électrode et un premier commutateur (10) étant associé à chaque deuxième électrode (4) pour connecter au choix la deuxième électrode correspondante soit à un générateur de tension d'enregistrement (7) commun à tous les commutateurs, soit aux amplificateurs de charges (8).

13. Procédé de détection d'images à mémoire dans lequel le détecteur selon l'une quelconque des revendications précédentes a été exposé à des rayonnements déterminant dans la première couche (2) de matériau photoconducteur une répartition de charges caractérisé en ce que la lecture de cette répartition de charges se fait par chauffage de la deuxième couche (3) de matériau à impédance variable.

# FIG_1

# FIG_2

# FIG_3

# FIG_4

# FIG_5

# FIG_6

# FIG_7

# FIG_8

## FIG_9

## FIG_10

# FIG_11

# FIG_12

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-3 693 171  (A.R. ASAM) <br> * En entier * | 1,10 | H 01 L   27/14 <br> H 01 L   37/02 <br> H 04 N    3/15 |
| A | | 9 | |
| | --- | | |
| Y | US-A-4 142 206  (R.D. ENNULAT) <br> * Colonne 2, ligne 12  -  colonne 3, ligne 12; colonne 4, lignes 7-28; revendications 1-6; figures 1,2,5,6 * | 1,10 | |
| A | | 2,11 | |
| | --- | | |
| A | DE-A-2 136 314  (INFRARED ENGINEERING LTD) <br> * Pages 5,6; page 8, lignes 4-15; page 9, ligne 1 - page 10, ligne 6; page 14, lignes 1-11; revendications; figures 1,2,7 * | 1,10-12 | |
| | --- | | |
| A | US-A-4 268 750  (R.W. COWART) <br><br> * & US-A-4 446 365 (Cat. D,A) * | | DOMAINES TECHNIQUES RECHERCHES (Int. Cl.4) <br><br> H 01 L <br> H 04 N |
| | --- | | |
| A | EP-A-0 109 712  (N.V. PHILIPS' GLOEILAMPENFABRIEKEN) <br><br> ---     -/- | | |

Le présent rapport de recherche a été établi pour toutes les revendications

| Lieu de la recherche <br> LA HAYE | Date d'achèvement de la recherche <br> 22-04-1987 | Examinateur <br> VISENTIN A. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82